# EUROPÄISCHE PATENTSCHRIFT

(11) **EP 4 086 590 B1**
(45) Veröffentlichungstag und Bekanntmachung des Hinweises auf die Patenterteilung: **14.06.2023**
(21) Anmeldenummer: 22000118.4
(22) Anmeldetag: 02.05.2022
(51) Int. Cl.: G01D 11/24, H03K 17/95

(54) **SENSORGEHÄUSE**
SENSOR CASING
BOÎTIER DE CAPTEUR

(30) Priorität: 04.05.2021 DE 102021002336
(43) Veröffentlichungstag der Anmeldung: 09.11.2022
(73) Patentinhaber: Pepperl+Fuchs SE, 68307 Mannheim (DE)
(72) Erfinder: Freund, Thomas, 68199 Mannheim (DE); Drebes, Patrick, 68199 Mannheim (DE)
(74) Vertreter: Koch Müller Patentanwaltsgesellschaft mbH

(56) Entgegenhaltungen:
- EP-A1- 0 677 857
- EP-A2- 0 998 042
- DE-A1- 2 819 782
- DE-A1- 3 324 242

## Beschreibung

Die Erfindung betrifft ein Sensorgehäuse umfassend ein Kopfteil mit einem Sensorraum zur Aufnahme eines Sensors und ein Anschlussteil mit einem Klemmraum zur Aufnahme eines Klemmanschlussblocks gemäß dem Oberbegriff des Patentanspruchs 1.

Aus der gattungsbildenden EP 0 677 857 A1 ist ein elektrischer Schalter mit Tastkopf bekannt, dessen Schaltergehäuse aus einem Unterteil und einem durch Rastelemente lösbar mit demselben verbundenen Oberteil besteht. Auf dem Oberteil ist eine Deckel verrastbar, welcher an einem Ende schwenkbar auf dem Oberteil gelagert ist und an seinem anderen, freien Ende eine Rastelement trägt, für das auf dem Oberteil eine Gegenrastelement vorgesehen ist.

Aus der DE 44 12 923 C1, der DE 28 19 782 A1, der DE 33 24 242 A1 und der EP 0 998 042 A2 sind weitere Schaltergehäuse bekannt.

Eine typische Bauform von Sensoren, wie induktiven oder kapazitativen Näherungssensoren, umfasst ein zweiteiliges Gehäuse. Der Sensor ist in einem Kopfteil angeordnet und in einem Anschlussteil wird eine Kontaktiervorrichtung, z.B. ein Klemmanschlussblock, zum Anschließen eines von außen kommenden Kabels angeordnet. Das Anschlussteil bzw. der von dem Anschlussteil umfasste Raum wird daher häufig auch als Klemmraum bezeichnet.

Der Sensor in dem Kopfteil ist durch elektrische Leitungen mit der Kontaktiervorrichtung verbunden, wofür das Kopfteil und das Anschlussteil entsprechende Durchgangsöffnungen und gegebenenfalls weitere Kontaktiervorrichtungen, wie z.B. Kontaktstifte, umfassen.

Um einen Zugang zu dem Klemmraum zu ermöglichen besteht das Anschlussteil typischerweise aus einem Unterteil und einem Deckel, wobei das Unterteil typischerweise Befestigungsmittel, z.B. Durchgangsbohrungen für Schrauben, zur Befestigung an einer Oberfläche aufweist. Das Kopfteil ist typischerweise mit dem Deckel des Anschlussteils verbunden.

Die Anschlussteildeckel des induktiven Näherungssensors NBB20-U1-UU oder des kapazitiven Sensors CJ15+U1+A2 der Fa. Pepperl + Fuchs GmbH werden jeweils mittels dreier Verbindungsschrauben mit dem Unterteil verbunden. Zwei der drei Schrauben dienen zusätzlich zur Fixierung des Kopfteils relativ zu dem Anschlussteil, indem die Schrauben in eine Nut eines von dem Kopfteil in das Anschlussteil hinein reichenden Verbindungsteils greifen.

Auch die Standardbauform der Baureihe IQ40 der Fa. SICK AG, z.B. der induktive Näherungssensor IQ40-NPPKKOS weist ein durch Schrauben verschlossenes Anschlussteil auf.

Der induktive Näherungssensor XS8C4A1PCG13 der zu der Fa. Schneider Electric SE gehörenden Marke Telemecanique Sensors weist einen mechanischen Riegel zur Fixierung des Kopfteils unabhängig von Verbindungsschrauben für das Anschlussteil auf. Unterteil und Deckel des Anschlussteils sind mittels dreier Schrauben miteinander verbunden.

Von der Fa. Rockwell Automation, Inc. sind Näherungssensoren, z.B. das Modell 871L oder 872L DC, mit einem Kopfteil und einem Anschlussteil bekannt, wobei der Deckel des Anschlussteils eine Deckplatte aufweist, welches als Entriegelungshebel zum Entriegeln einer Verbindung zwischen Deckel und Boden des Anschlussteils dient. Der Entriegelungshebel muss mithilfe eines Werkzeugs gelöst werden.

Des Weiteren beschreibt die DE 28 19 782 A1 einen Näherungssensor mit einem Grundgehäuse, welches mit einem Messkopfteil verbunden ist. Das Grundgehäuse umfasst ein Unterteil und ein Oberteil, welche durch eine vertikale Relativbewegung zusammengefügt werden. Die Verbindung zwischen dem Unterteil und dem Oberteil erfolgt über Steckverbinder.

Ein Näherungssensor gemäß der DE 81 04 480 U1 besteht aus einem topfförmigen Anschlussgehäuse mit einem daran befestigbaren Deckel sowie einem mit dem Anschlussgehäuse lösbar verbundenen Tastkopf. Der Tastkopf weist einen Stecker auf, so dass mit demselben die lösbare Verbindung mit dem Anschlussgehäuse herstellbar ist.

Schließlich ist auch aus der US 6 635 833 B2 ein Näherungssensor mit einem einen Sensor aufnehmenden Kopfteil, welches an einem 2-teiligen Gehäuse angeordnet ist, bekannt. Das 2-teilige Gehäuse nimmt einen Klemmanschlussblock auf und besteht aus einem topfförmigen Grundgehäuse, welches mit einem haubenförmigen Deckel verschließbar ist. Stirnseitig des 2-teiligen Gehäuses bildet das Grundgehäuse zusammen mit dem haubenförmigen Deckel eine fluiddichte Durchgangsöffnung zur Durchführung eines Anschlusskabels.

Vor diesem Hintergrund besteht die Aufgabe der Erfindung darin, eine Vorrichtung anzugeben, die den Stand der Technik weiterbildet.

Insbesondere soll ein Sensorgehäuse mit einem einfachen, intuitiv zugänglichen und werkzeuglos bedienbaren Mechanismus für die Verbindung zwischen dem Deckel und Unterteil des Anschlussteils bereitgestellt werden.

Die Aufgabe wird durch eine Vorrichtung mit den Merkmalen des Patentanspruchs 1 gelöst. Vorteilhafte Ausgestaltungen der Erfindung sind Gegenstand von Unteransprüchen.

Gemäß dem Gegenstand der Erfindung wird ein Sensorgehäuse bereitgestellt, umfassend ein Kopfteil mit einem Sensorraum zur Aufnahme eines Sensors und ein an das Kopfteil angrenzendes Anschlussteil mit einem Klemmraum zur Aufnahme eines Klemmanschlussblocks.

Das Kopfteil weist in einer an das Anschlussteil angrenzenden Rückwand eine Durchgangsöffnung zur Kabel- und/oder Steckerdurchführung in den Sensorraum auf. Das Anschlussteil umfasst ein Klemmraumunterteil und einen Klemmraumdeckel auf, wobei das Klemmraumunterteil und der Klemmraumdeckel entlang einer Schließrichtung zusammengesetzt sind, so dass das Klemmraumunterteil und der Klemmraumdeckel den Klemmraum umschließen.

Der Klemmraumdeckel oder das Klemmraumunterteil ist mittels eines Verbindungsmittels mit dem Kopfteil verbunden und weist eine an die Rückwand des Kopfteils angrenzende Seitenwand mit einer mit der Durchgangsöffnung des Kopfteils zumindest überlappenden Durchgangsöffnung zur Kabel- und/oder Steckerdurchführung von dem Sensorraum in den Klemmraum auf.

Das Klemmraumunterteil oder der Klemmraumdeckel weist eine Seitenwand mit einer Eingangsöffnung zur Kabel- und/oder Steckerdurchführung auf.

Das Klemmraumunterteil weist mindestens ein erstes Verbindungsteil einer in einer Verriegelungsrichtung ineinandergreifenden Steckverbindung auf.

Der Klemmraumdeckel umfasst ein Innenteil und ein Abdeckteil, wobei das Innenteil eine Führung aufweist und das Abdeckteil mindestens ein zweites Verbindungsteil der in der Verriegelungsrichtung ineinandergreifenden Steckverbindung aufweist.

Das Abdeckteil ist gegenüber dem Innenteil entlang einer Führung entlang der Verriegelungsrichtung zwischen einer Anfangsposition und einer Endposition verschiebbar ausgebildet, wobei das Abdeckteil das Innenteil zumindest in der Endposition teilweise überdeckt.

Bei auf dem Klemmraumunterteil aufgesetztem Klemmraumdeckels greifen das erste Verbindungsteil und das zweite Verbindungsteil der Steckverbindung in der Endposition ineinander, während das erste Verbindungsteil und das zweite Verbindungsteil der Steckverbindung in der Anfangsposition des Abdeckteils zueinander beabstandet sind.

Es versteht sich, dass die Begriffe Klemmraumunterteil und Klemmraumdeckel keine Ausrichtung des Anschlussteils bzw. keine Position/Ausrichtung der beiden Teile des Anschlussteils vorgeben. Die Begriffe dienen lediglich zur Unterscheidung bzw. zur Kennzeichnung der beiden Teile des zweiteiligen Anschlussteils.

Außerdem umschließen der Klemmraumdeckel und das Klemmraumunterteil den Klemmraum offensichtlich nicht vollständig bzw. nur soweit, dass die Eingangsöffnung sowie die Durchgangsöffnung zur Kabel- und/oder Steckerdurchführung in den Klemmraum offen bleiben.

Die einfachste Form für das Anschlussteil ist ein Quader mit einem Boden, einer Decke und vier Seitenwänden, wobei das Klemmraumunterteil den Boden und jeweils einen Teil jeder Seitenwand und der Klemmraumdeckel die Decke und jeweils den restlichen Teil jeder Seitenwand umfasst.

Ebenso ist es möglich, dass eine Seitenwand des Anschlussteils vollständig von dem Klemmraumdeckel oder vollständig von dem Klemmraumunterteil umfasst wird, so dass diese Seitenwand im zusammengesetzten Zustand direkt an den Boden bzw. die Decke des Gegenstücks angrenzt.

Es versteht sich auch, dass der Klemmblock sowohl als separates Bauteil oder auch einstückig mit dem Anschlussteil, also mit dem Klemmraumunterteil oder auch dem Innenteil des Klemmraumdeckels, ausgebildet sein kann.

Die Verriegelungsrichtung verläuft von der Anfangsposition in Richtung der Endposition. Zum Entriegeln wird das Abdeckteil entsprechend entgegen der Verriegelungsrichtung bewegt und die Steckverbindung hierdurch gelöst, so dass Klemmraumdeckel und Klemmraumunterteil entgegen der Schließrichtung voneinander getrennt werden können.

Das Abdeckteil dient der Verbindung von Klemmraumunterteil und Klemmraumdeckel bzw. zur Ent- bzw. Verriegelung der beiden Teile. Hierfür ist das Abdeckteil an dem Innenteil so angeordnet, dass es von außen gegriffen und entlang der Verriegelungsrichtung, also zumindest innerhalb der Anfangsposition und der Endposition sowohl in Verriegelungsrichtung als auch entgegen der Verriegelungsrichtung, durch die Führung geführt verschoben werden kann.

Es versteht sich, dass die beiden Verbindungsteile der Steckverbindung entlang der Verriegelungsrichtung ineinander fügbar sind, so dass die beiden Verbindungsteile in der Endposition formschlüssig ineinandergreifen. Durch den Formschluss wird eine Bewegung senkrecht zu der Verriegelungsrichtung verhindert. Ein Lösen der Steckverbindung ist nur durch Trennen der beiden Verbindungsteile durch eine entgegen der Verriegelungsrichtung gerichtete Bewegung möglich.

Die Steckverbindung umfasst beispielsweise einen Stift als erstes oder zweites Verbindungsteil und eine entsprechende Ausnehmung als zweites bzw. erstes Verbindungsteil.

Durch die Verbindung des Kopfteils mit dem Klemmraumdeckel oder des Klemmraumunterteils mittels des Verbindungmittels bzw. die Befestigung des Kopfteils an einem der Teile des Anschlussteils verbleibt das Kopfteil beim Öffnen des Klemmraums an dem Klemmraumdeckel bzw. Klemmraumunterteil. Die Verbindung des Kopfteils mit dem Anschlussteil ist dadurch unabhängig von der Verbindung zwischen Klemmraumunterteil und Klemmraumdeckel. Es wird sichergestellt, dass das Kopfteil beim Öffnen des Klemmraums nicht herunterfallen kann. Unnötiger Stress oder Zug auf die von dem Klemmraum in den Sensorraum verlaufenden Kabel und/oder Stecker wird vermieden. Andererseits kann das Kopfteil zusammen mit dem entsprechenden Teil des Anschlussteils auf einfache Weise werkzeuglos abgenommen werden, beispielsweise um eine Ausrichtung des Kopfteils gegenüber dem Anschlussteil zu ändern.

Das erfindungsgemäße Sensorgehäuse ermöglicht einen einfachen, schnellen und werkzeuglosen Zugang zu dem Klemmraum bzw. ein einfaches, werkzeugloses Abnehmen des Kopfteils zusammen mit dem Klemmraumdeckel.

Insbesondere ist keine Schraubverbindung notwendig, welches das Mitführen eines Werkzeugs voraussetzt, zeitaufwändiger ist und häufig metallische und damit elektrisch leitfähige Teile umfasst. Das erfindungsgemäße Sensorgehäuse kann aus einem einzigen Material gefertigt werden, z.B. einem Kunststoff und ist dadurch besonders einfach und Kostengünstig herstellbar.

Gemäß einer ersten Ausführungsform umfasst das Anschlussteil mindestens zwei Steckverbindungen, wobei das Abdeckteil des Klemmraumdeckels zwei einander gegenüberliegende und zur Verriegelungsrichtung parallel verlaufende Seitenwände mit jeweils mindestens einem zweiten Verbindungsteilen der mindestens zwei Steckverbindungen aufweist.

In einer besonders stabilen Weiterbildung weist das Anschlussteil mindestens vier Steckverbindungen auf.

Gemäß einer weiteren Weiterbildung weist das Klemmraumunterteil und/oder der Klemmraumdeckel mindestens eine Sperrvorrichtung zum Festhalten des Abdeckteils in der Endstellung auf. Die Sperrvorrichtung ist entweder vollständig an dem Klemmraumunterteil oder vollständig an dem Klemmraumdeckel angeordnet oder es sind jeweils Teile der Sperrvorrichtung an dem Klemmraumunterteil und an dem Klemmraumdeckel angeordnet.

Gemäß einer ersten Ausführungsform umfasst die Sperrvorrichtung eine Drucktaste und ein Rückstellmittel, wobei die Drucktaste von einer Verriegelungsstellung durch Krafteinwirkung in einer senkrecht zu der Verriegelungsrichtung verlaufenden Entsperrrichtung in eine Entsperrstellung bewegbar ist. Die Drucktaste ist nach einem Ende der Krafteinwirkung durch das Rückstellmittel in die Sperrstellung bewegbar.

In einer Weiterbildung ist die Drucktaste an dem Innenteil des Klemmraumdeckels oder an dem Abdeckteil des Klemmraumdeckels angeordnet, wobei das Rückstellmittel an dem Innenteil oder an dem Abdeckteil angeordnet ist. Gemäß einer weiteren Weiterbildung ist die Drucktaste in der Endposition des Abdeckteils in der Verriegelungsrichtung zumindest teilweise vor dem Abdeckteil angeordnet und weist eine in der Endposition des Abdeckteils an das Abdeckteil angrenzende Haltefläche auf. So wird eine einfache Fixierung/Sicherung der Verbindung zwischen Klemmraumdeckel und Klemmraumunterteil bereitgestellt, die werkzeuglos bedienbar ist.

Gemäß einer anderen Ausführungsform verläuft eine Fügefläche zwischen mindestens einer parallel zu der Verriegelungsrichtung verlaufenden Seitenwand des Klemmraumunterteils und mindestens einer parallel zu der Verriegelungsrichtung verlaufenden Seitenwand des Klemmraumdeckels zumindest teilweise parallel zu der Verriegelungsrichtung und/oder zumindest teilweise unter einem Winkel zu der Verriegelungsrichtung.

Gemäß einer weiteren Ausführungsform schließt die Schließrichtung mit der Verriegelungsrichtung einen Winkel von mindestens 0° oder mindestens 15° oder mindestens 30° und von höchstens 90° ein.

In einer anderen Weiterbildung entspricht das Sensorgehäuse dem IP 68 Standard oder dem IP 69K Standard.

In einer weiteren Weiterbildung weist das Klemmraumunterteil und/oder der Klemmraumdeckel mindestens ein Befestigungsmittel oder zumindest einen Teil eines Befestigungsmittels zur Befestigung des Sensorgehäuses an einer Oberfläche auf.

Gemäß einer anderen Ausführungsform weist das Abdeckteil des Klemmraumdeckels in einer senkrecht zu der Verriegelungsrichtung verlaufenden Ebene einen U-förmig Verlauf auf.

Gemäß einer weiteren Ausführungsform besteht das Sensorgehäuse vollständig aus einem oder mehreren nicht elektrisch leitfähigen Materialien, z.B. aus einem Kunststoff oder aus mehreren unterschiedlichen Kunststoffen.

In einer Weiterbildung wird ein induktiver oder kapazitiver Näherungssensor bereitgestellt, wobei der Näherungssensor ein Sensorgehäuse der vorbeschriebenen Art aufweist.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigten, die
- Figur 1: eine seitliche Ansicht einer ersten erfindungsgemäße Ausführungsform eines Sensorgehäuses,
- Figur 2: eine Schnittansicht entlang AA eines Klemmraumdeckels gemäß der ersten erfindungsgemäßen Ausführungsform,
- Figur 3: eine Aufsicht auf die erste erfindungsgemäße Ausführungsform des Sensorgehäuses,
- Figur 4: eine seitliche Ansicht eines geöffneten Sensorgehäuses gemäß der ersten Ausführungsform,
- Figur 5: eine perspektivische Ansicht der ersten erfindungsgemäßen Ausführungsform des Sensorgehäuses.

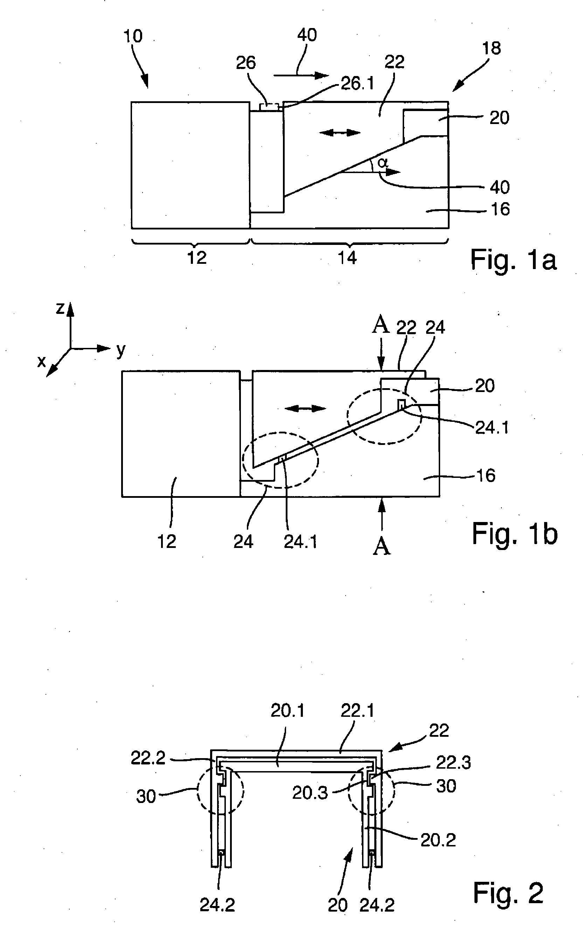

Die Abbildung der Figur 1 zeigt zwei seitliche Ansichten einer ersten erfindungsgemäßen Ausführungsform eines Sensorgehäuse 10, umfassend ein Kopfteil 12 mit einem Sensorraum zur Aufnahme eines Sensors und ein an das Kopfteil 12 angrenzendes Anschlussteil 14 mit einem Klemmraum zur Aufnahme eines Klemmanschlussblocks.

Das Anschlussteil besteht aus einem Klemmraumunterteil 16 und einem Klemmraumdeckel 18, die aneinander angrenzen und den Klemmraum umschließen und für einen Zugang zu dem Klemmraum getrennt werden können.

Nicht dargestellt sind die Durchgangsöffnungen für die Kabel- und/oder Steckerdurchführung zwischen dem Sensorraum und dem Klemmraum bzw. in den Klemmraum. Hierfür weist eine an das Anschlussteil 14 angrenzende Rückwand des Kopfteils 12 eine erste Durchgangsöffnung und eine an das Kopfteil 12 angrenzenden Seitenwand des Klemmraumdeckels 18 eine mit der ersten Durchgangsöffnung zumindest überlappende zweite Durchgangsöffnung auf.

Außerdem weist eine Seitenwand des Klemmraumunterteils 16 eine Eingangsöffnung zur Kabel- und/oder Steckerdurchführung von außen in den Klemmraum auf.

Das Kopfteil 12 ist mittels eines ebenfalls nicht dargestellten Verbindungsmittels mit dem Klemmraumdeckel 18 verbunden.

Klemmraumdeckel 18 und Klemmraumunterteil 16 sind mittels einer Steckverbindung 24 miteinander verbunden. Hierfür umfasst der Klemmraumdeckel 18 ein Innenteil 20 und ein gegenüber dem Innenteil entlang einer Führung 30 entlang einer Verriegelungsrichtung 40 zwischen einer Anfangsposition (Abbildungsteil (b)) und einer Endposition (Abbildungsteil (a)) verschiebbares Abdeckteil 22. Ein Querschnitt des Klemmraumdeckels 18 entlang der Linie AA ist in Figur 2 dargestellt.

Das Innenteil 20 weist eine Decke 20.1 und umlaufende Seitenwänden 20.2 auf. Das Abdeckteil 22 ist u-förmig und weist eine Decke 22.1 und zwei einander gegenüberliegende Seitenwände 22.2 auf und umschließt die Decke 20.1 sowie zwei einander gegenüberliegende Seitenwände 20.2 des Innenteils 20 zumindest teilweise.

Die Führung 30 besteht aus jeweils einer an einer Innenseite der Seitenwände 22.2 des Abdeckteils 22 angeordneten Führungsnase 22.3 und je einer Führungsnut 20.3 an einer Außenseiten einer der umschlossenen Seitenwände 20.2 des Innenteils 20. Die Führungsnase 22.3 und die Führungsnut 20.3 erstrecken sich jeweils parallel zu der Verriegelungsrichtung 40 entlang der jeweiligen Seitenwand, wobei jeweils eine Führungsnut 20.3 und eine Führungsnase 22.3 einander gegenüberliegen und ineinander greifen.

Die Steckverbindung 24 besteht aus mindestens einem ersten Verbindungsteil an dem Abdeckteil 22 des Klemmraumdeckels 18 und mindestens einem zweiten Verbindungsteil an dem Klemmraumunterteil 16, wobei jedes erste Verbindungsteil in Verriegelungsrichtung 40 mit dem zweiten Verbindungsteil formschlüssig verbunden bzw. entgegen der Verriegelungsrichtung 40 von dem zweiten Verbindungsteil getrennt werden kann.

In dem dargestellten Ausführungsbeispiel sind als zweite Verbindungsteile jeweils zwei buchsenartige Steckaufnahmen 24.1, z.B. quaderförmige Körper mit parallel zu der Verriegelungsrichtung 40 verlaufender Durchgangsbohrung oder Sackloch, an zwei einander gegenüberliegenden Seitenwänden des Klemmraumunterteils 16 angeordnet. Als erste Verbindungsteile weist das Abdeckteil 22 des Klemmraumdeckels 18 vier Stifte 24.2 auf, wobei jeder Stift 24.2 parallel zu der Verriegelungsrichtung 40 und in einem Abstand zu einer Innenseite der Seitenwand 22.2 des Abdeckteils 22 verläuft und mittels eines Verbindungsstücks an der Innenseite des Abdeckteils 22 angebracht ist.

Die Verbindungsteile der Steckverbindung 24 sind so angeordnet, dass sie in Verriegelungsrichtung 40 ineinandergreifen. In der Endposition (Abbildungsteil (a) der Figur 1) greifen die vier Stifte 24.2 des Abdeckteils 22 des Klemmraumdeckels 18 jeweils formschlüssig in eine Steckaufnahme 24.1 des Klemmraumunterteils 16. In der Anfangsposition (Abbildungsteil (b) der Figur 1) ist die Steckverbindung 24 gelöst bzw. sind die Steckaufnahmen 24.1 zu den Stiften 24.2 beabstandet.

Es versteht sich, dass es ebenso möglich ist, die Stifte an dem Klemmraumunterteil 16 und die Steckaufnahmen 24.1 an dem Abdeckteil 22 des Klemmraumdeckels 18 anzuordnen.

Gemäß einer Weiterbildung weist das Anschlussteil 14 eine Sperrvorrichtung 26 zum Festhalten des Abdeckteils in der Endstellung auf, um das Abdeckteil 22 relativ zu dem Innenteil 20 des Klemmraumdeckels 18 in der Endposition zu fixieren. Wie in dem Abbildungsteil (a) der Figur 1 gestrichelt dargestellt, ist die Sperrvorrichtung gemäß einer ersten Ausführungsform als an dem Innentell 20 des Klemmraumdeckels 18 angeordnete Drucktaste 26 ausgebildet, wobei die Drucktaste in der Endposition des Abdeckteils 22 entlang der Verriegelungsrichtung 40 vor dem Abdeckteil 22 angeordnet ist und eine in der Endposition des Abdeckteils 22 an das Abdeckteil 22 angrenzende Haltefläche 26.1 aufweist.

Die Drucktaste ist mit einem Rückstellmittel verbunden, z.B. einer Feder, so dass die Drucktaste von einer Sperrstellung durch Krafteinwirkung in einer senkrecht zu der Verriegelungsrichtung 40 verlaufenden Entsperrrichtung in eine Entsperrstellung und die Drucktaste nach einem Ende der Krafteinwirkung durch den Rückstellmittel in die Sperrstellung bewegbar ist.

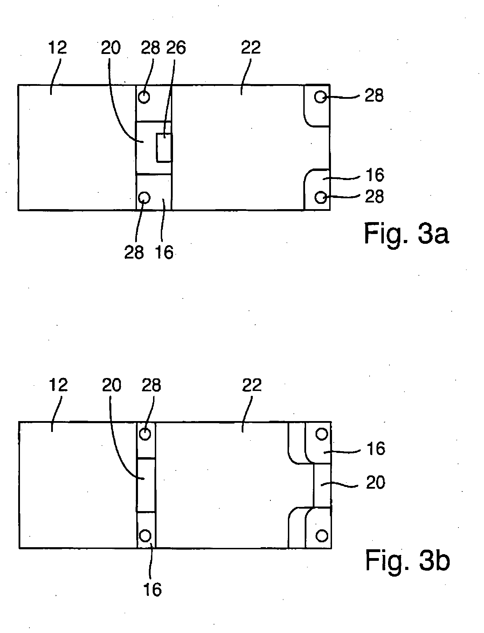

In der Abbildung der Figur 3 ist eine Aufsicht auf das Sensorgehäuse dargestellt. Im Folgenden werden jeweils nur die Unterschiede zu der Figur 1 erläutert.

In Abbildungsteil (a) befindet sich das Abdeckteil 22 in der Endposition. Die Endposition ist durch die Drucktaste 26 fixiert. Das Klemmraumunterteil 16 weist vier Durchgangsbohrungen 28 zur Befestigung bzw. als Teil eines Befestigungsmittels auf.

In Abbildungsteil (b) befindet sich das Abdeckteil 22 in der Anfangsposition. Die Drucktaste 26 befindet sich in der Entriegelungsstellung und ist in der dargestellten Aufsicht vollständig von dem Abdeckteil 22 verdeckt.

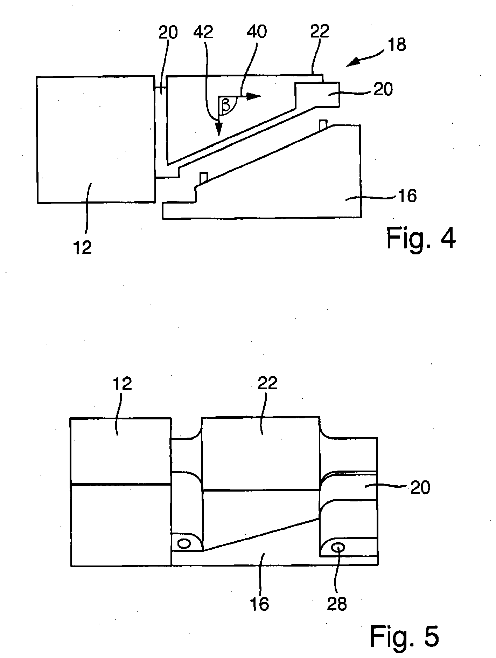

Die Abbildung der Figur 4 zeigt eine seitliche Ansicht des Sensorgehäuses 10 mit geöffnetem Klemmraum, also von dem Klemmraumunterteil 16 getrenntem Klemmraumdeckel 18.

In der Abbildung der Figur 5 ist das Sensorgehäuse 10 in geschlossenem Zustand und mit dem Abdeckteil 22 in der Endposition perspektivisch dargestellt.

## Patentansprüche

1. Sensorgehäuse (10), umfassend ein Kopfteil (12) mit einem Sensorraum zur Aufnahme eines Sensors und ein an das Kopfteil (12) angrenzendes Anschlussteil (14) mit einem Klemmraum zur Aufnahme eines Klemmanschlussblocks, wobei
- das Kopfteil (12) in einer an das Anschlussteil (14) angrenzenden Rückwand eine Durchgangsöffnung zur Kabel- und/oder Steckerdurchführung in den Sensorraum aufweist,
- das Anschlussteil (14) ein Klemmraumunterteil (16) und einen Klemmraumdeckel (18) umfasst,
- das Klemmraumunterteil (16) und der Klemmraumdeckel (18) in einer Schließrichtung (42) zusammengesetzt sind, so dass
- das Klemmraumunterteil (16) und der Klemmraumdeckel (18) den Klemmraum umschließen,
- der Klemmraumdeckel (18) oder das Klemmraumunterteil (16) mittels eines Verbindungsmittels mit dem Kopfteil (12) verbunden ist und eine an die Rückwand des Kopfteils (12) angrenzende Seitenwand mit einer mit der Durchgangsöffnung des Kopfteils (12) zumindest überlappenden Durchgangsöffnung zur Kabel- und/oder Steckerdurchführung von dem Sensorraum in den Klemmraum aufweist,
- das Klemmraumunterteil (16) oder der Klemmraumdeckel (18) eine Seitenwand mit einer Eingangsöffnung zur Kabel- und/oder Steckerdurchführung aufweist,
wobei
- das Klemmraumunterteil (16) mindestens ein erstes Verbindungsteil (24.1) einer in einer Verriegelungsrichtung (40) ineinandergreifenden Steckverbindung (24) aufweist,
**dadurch gekennzeichnet, dass**
- der Klemmraumdeckel (18) ein Innenteil (20) mit einer Führung (30) und ein Abdeckteil (22) mit mindestens einem zweiten Verbindungsteil (24.2) der in der Verriegelungsrichtung (40) ineinandergreifenden Steckverbindung (24) aufweist,
- das Abdeckteil (22) gegenüber dem Innenteil (20) entlang der Führung (30) entlang der Verriegelungsrichtung (40) zwischen einer Anfangsposition und einer Endposition verschiebbar ausgebildet ist,
- das Abdeckteil (22) das Innenteil (20) zumindest in der Endposition teilweise überdeckt und
- bei auf dem Klemmraumunterteil (16) aufgesetztem Klemmraumdeckel (18) das erste Verbindungsteil (24.1) und das zweite Verbindungsteil (24.2) der Steckverbindung (24) in der Endposition des Abdeckteils (22) ineinander greifen und in der Anfangsposition des Abdeckteils (22) zueinander beabstandet sind.

2. Sensorgehäuse (10) nach Anspruch 1, **dadurch gekennzeichnet, dass** das Anschlussteil (14) mindestens zwei Steckverbindungen (24) umfasst, wobei das Abdeckteil (22) des Klemmraumdeckels (18) zwei einander gegenüberliegende und zur Verriegelungsrichtung (40) parallel verlaufende Seitenwände mit jeweils mindestens einem zweiten Verbindungsteil (24.2) der mindestens zwei Steckverbindungen (24) aufweist.

3. Sensorgehäuse (10) nach einem der vorangegangenen Ansprüche, **dadurch gekennzeichnet, dass** das Klemmraumunterteil (16) und/oder der Klemmraumdeckel (18) mindestens eine Sperrvorrichtung (26) zum Festhalten des Abdeckteils (22) in der Endstellung aufweisen.

4. Sensorgehäuse (10) nach Anspruch 3, **dadurch gekennzeichnet, dass** die Sperrvorrichtung (26) eine Drucktaste und ein Rückstellmittel umfasst, wobei die Drucktaste von einer Sperrstellung durch Krafteinwirkung in einer senkrecht zu der Verriegelungsrichtung (40) verlaufenden Entsperrrichtung in eine Entsperrstellung bewegbar ist und die Drucktaste nach einem Ende der Krafteinwirkung durch das Rückstellmittel in die Sperrstellung bewegbar ist.

5. Sensorgehäuse (10) nach Anspruch 4, **dadurch gekennzeichnet, dass** die Drucktaste an dem Innenteil (20) des Klemmraumdeckels (18) oder an dem Abdeckteil (22) des Klemmraumdeckels (18) angeordnet ist, wobei das Rückstellmittel an dem Innenteil (20) oder an dem Abdeckteil (22) angeordnet ist.

6. Sensorgehäuse (10) nach Anspruch 4 oder 5, **dadurch gekennzeichnet, dass** die Drucktaste in der Endposition des Abdeckteils (22) in der Verriegelungsrichtung (40) zumindest teilweise vor dem Abdeckteil (22) angeordnet ist und die Drucktaste eine in der Endposition des Abdeckteils (22) an das Abdeckteil (22) angrenzende Haltefläche (26.1) aufweist.

7. Sensorgehäuse (10) nach einem der vorangegangenen Ansprüche, **dadurch gekennzeichnet, dass** eine Fügefläche zwischen mindestens einer parallel zu der Verriegelungsrichtung (40) verlaufenden Seitenwand des Klemmraumunterteils (16) und mindestens einer parallel zu der Verriegelungsrichtung (40) verlaufenden Seitenwand des Klemmraumdeckels (18) zumindest teilweise parallel zu der Verriegelungsrichtung (40) verläuft und/oder zumindest teilweise unter einem Winkel (a) zu der Verriegelungsrichtung (40) verläuft.

8. Sensorgehäuse (10) nach einem der vorangegangenen Ansprüche, **dadurch gekennzeichnet, dass** die Schließrichtung (42) mit der Verriegelungsrichtung (40) einen Winkel (β) von mindestens 0° oder mindestens 15° oder mindestens 30° und von höchstens 90° einschließt.

9. Sensorgehäuse (10) nach einem der vorangegangenen Ansprüche, **dadurch gekennzeichnet, dass** das Sensorgehäuse (10) dem IP 68 Standard oder dem IP 69K Standard entspricht.

10. Sensorgehäuse (10) nach einem der vorangegangenen Ansprüche, **dadurch gekennzeichnet, dass** das Klemmraumunterteil (16) und/oder der Klemmraumdeckel (18) mindestens ein Befestigungsmittel (28) oder zumindest einen Teil eines Befestigungsmittels (28) zur Befestigung des Sensorgehäuses (10) an einer Oberfläche aufweisen.

11. Sensorgehäuse (10) nach einem der vorangegangenen Ansprüche, **dadurch gekennzeichnet, dass** das Abdeckteil (22) des Klemmraumdeckels (18) in einer senkrecht zu der Verriegelungsrichtung (40) verlaufenden Ebene einen U-förmig Verlauf aufweist.

12. Sensorgehäuse (10) nach einem der vorangegangenen Ansprüche, **dadurch gekennzeichnet, dass** das Sensorgehäuse vollständig aus einem oder mehreren nicht elektrisch leitfähigen Materialien besteht.

13. Induktiver Näherungssensor oder kapazitiver Näherungssensor, **dadurch gekennzeichnet, dass** der Näherungssensor ein Sensorgehäuse (10) gemäß einem der vorangegangenen Ansprüche aufweist.

## Claims

1. Sensor casing (10) comprising a head part (12) with a sensor space for reception of a sensor and a connecting part (14), which adjoins the head part (12), with a terminal space for reception of a terminal connecting block, wherein
- the head part (12) has in a back wall adjoining the connecting part (14) a passage opening for cable and plug guidance into the sensor space,
- the connecting part (14) comprises a terminal space lower part (16) and a terminal space cover (18),
- the terminal space lower part (16) and the terminal space cover (18) are placed together in a closing direction (42) so that
- the terminal space lower part (16) and the terminal space cover part (18) enclose the terminal space,
- the terminal space over (18) or the terminal space lower part (16) is connected by way of connecting means with the head part (12) and has a side wall, which adjoins the back wall of the head part (12), with a passage opening, which at least overlaps the passage opening of the head part (12), for the cable and/or plug guidance from the sensor space into the terminal space,
- the terminal space lower part (16) or the terminal space cover (18) has a side wall with an entry opening for the cable and/or plug guidance, wherein
- the terminal space lower part (16) comprises at least one first connecting part (24.1) of a plug connection (24) interengaging in a locking direction (40),
**characterised in that**
- the terminal space cover (18) comprises an inner part (20) with a guide (30) and a cover part (22) with at least one second connecting part (24.2) of the plug connection (24) interengaging in the locking direction (40),
- the cover part (22) is configured to be displaceable relative to the inner part (20) along the guide (30) in the locking direction (40) between a starting position and an end position,
- the cover part (22) partly covers the inner part (20) at least in the end position and
- when the terminal space cover (18) is placed on the terminal space lower part (16) the first connecting part (24.1) and the second connecting part (24.2) of the plug connection (24) engage one in the other in the end position of the cover part (22) and are spaced from one another in the starting position of the cover part (22).

2. Sensor casing (10) according to claim 1, **characterised in that** the connecting part (14) comprises at least two plug connections (24), wherein the cover part (22) of the terminal space cover (18) comprises two mutually opposite side walls, which extend parallelly to the locking direction (40), each with at least one second connecting part (24.2) of the at least two plug connections (24).

3. Sensor casing (10) according to one of the preceding claims, **characterised in that** the terminal space lower part (16) and/or the terminal space cover (18) comprises or comprise at least one blocking device (26) for fixing the cover part (22) in the end setting.

4. Sensor casing (10) according to claim 3, **characterised in that** the blocking device (26) comprises a pushbutton and restoring means, wherein the pushbutton is movable from a blocking setting to an unblocking setting by force action in an unblocking direction extending perpendicularly to the locking direction (40) and the pushbutton after the end of the force action is movable by the restoring means into the blocking setting.

5. Sensor casing (10) according to claim 4, **characterised in that** the pushbutton is arranged at the inner part (20) of the terminal space cover (18) or at the cover part (22) of the terminal space cover (18), wherein the restoring means is arranged at the inner part (20) or at the cover part (22).

6. Sensor casing (10) according to claim 4 or 5, **characterised in that** the pushbutton in the end position of the cover part (22) is arranged at least partly in front of the cover part (22) in the locking direction (40) and the pushbutton has a holding surface (26.1) adjoining the cover part (22) in the end position of the cover part (22).

7. Sensor casing (10) according to any one of the preceding claims, **characterised in that** a joining surface extends between at least one side wall, which runs parallel to the locking direction (40), of the terminal space lower part (16) and at least one side wall, which runs parallel to the locking direction (40), of the terminal space cover (18) at least partly parallel to the locking direction (40) and/or at least partly at an angle (a) to the locking direction (40).

8. Sensor casing (10) according to any one of the preceding claims, **characterised in that** the closing direction (42) includes with the locking direction (40) an angle (β) of at least 0° or at least 15° or at least 30° and at most 90°.

9. Sensor casing (10) according to any one of the preceding claims, **characterised in that** the sensor casing (10) corresponds with the IP 68 standard or the IP 69K standard.

10. Sensor casing (10) according to any one of the preceding claims, **characterised in that** the terminal space lower part (16) and/or the terminal space cover (18) comprises or comprise at least one fastening means (28) or at least one part of a fastening means (28) for fastening the sensor casing (10) to a surface.

11. Sensor casing (10) according to any one of the preceding claims, **characterised in that** the cover part (22) of the terminal space cover (18) has a U-shaped course in a plane extending perpendicularly to the locking direction (40).

12. Sensor casing (10) according to any one of the preceding claims, **characterised in that** the sensor casing consists entirely of one or more non-electrically conductive materials.

13. Inductive proximity sensor or capacitive proximity sensor, **characterised in that** the proximity sensor comprises a sensor casing (10) according to any one of the preceding claims.

## Revendications

1. Boîtier de détecteur (10) comprenant un élément de tête (12) avec une chambre de détecteur pour recevoir un détecteur et un élément de raccordement (14) contigu à l'élément de tête (12) avec une chambre de serrage pour recevoir un bloc de raccordement par serrage, dans lequel
- l'élément de tête (12) présente dans une paroi arrière contigüe à l'élément de raccordement (14) une ouverture de passage pour introduire des câbles et/ou des connecteurs dans la chambre de détecteur,
- l'élément de raccordement (14) comprend un socle de chambre de serrage (16) et un couvercle de chambre de serrage (18),
- le socle de chambre de serrage (16) et le couvercle de chambre de serrage (18) s'assemblent dans une direction de fermeture (42) de telle sorte que
- le socle de chambre de serrage (16) et le couvercle de chambre de serrage (18) enveloppent la chambre de serrage (18),
- le couvercle de chambre de serrage (18) ou le socle de chambre de serrage (16) est raccordé avec l'élément de tête (12) au moyen d'un moyen de raccordement et présente une paroi latérale contigüe à la paroi arrière de l'élément de tête (12) avec une ouverture de passage se chevauchant au moins avec l'ouverture de passage de l'élément de tête (12) pour faire passer les câbles et/ou les connecteurs de la chambre de détecteur à la chambre de serrage,
- le socle de chambre de serrage (16) ou le couvercle de chambre de serrage (18) présente une paroi latérale avec une ouverture d'entrée pour le passage des câbles et/ou des connecteurs
et
- le socle de chambre de serrage (16) présente au moins un premier élément de raccordement (24.1) d'un raccord enfichable (24) s'emboîtant dans une direction de verrouillage (40),
**caractérisé en ce que**
- le couvercle de chambre de serrage (18) comporte un élément intérieur (20) avec une glissière (30) et un élément de capot (22) avec au moins un deuxième élément de raccordement (24.2) du raccord enfichable (24) s'emboîtant dans la direction de verrouillage (40),
- l'élément de capot (22) est configuré de façon à coulisser le long de la glissière (30) par rapport à l'élément intérieur (20), entre une position initiale et une position finale le long de la direction de verrouillage (40),
- l'élément de capot (22) recouvre au moins partiellement l'élément intérieur (20) dans la position finale et
- lorsque le couvercle de chambre de serrage (18) est posé sur le socle de chambre de serrage (16), le premier élément de raccordement (24.1) et le deuxième élément de raccordement (24.2) du raccord enfichable (24) s'imbriquent l'un dans l'autre dans la position finale de l'élément de capot (22) et sont écartés l'un de l'autre dans la position initiale de l'élément de capot (22).

2. Boîtier de détecteur (10) selon la revendication 1, **caractérisé en ce que** l'élément de raccordement (14) comprend au moins deux raccords enfichables (24), l'élément de capot (22) du couvercle de chambre de serrage (18) comportant deux parois latérales se faisant face entre elles et courant parallèlement à la direction de verrouillage (40) avec chacune au moins un deuxième élément de raccordement (24.2) des au moins deux raccords enfichables (24).

3. Boîtier de détecteur (10) selon une des revendications précédentes, **caractérisé en ce que** le socle de chambre de serrage (16) et/ou le couvercle de chambre de serrage (18) présentent au moins un dispositif de blocage (26) pour maintenir l'élément de capot (22) dans la position finale.

4. Boîtier de détecteur (10) selon la revendication 3, **caractérisé en ce que** le dispositif de blocage (26) comprend un bouton poussoir et un moyen de rappel, le bouton poussoir pouvant passer, en appliquant une force dans une direction de déblocage courant perpendiculairement à la direction de verrouillage (40), d'une position de blocage à une position de déblocage, et le bouton poussoir pouvant passer dans la position de blocage après une fin de l'application de force par le biais du moyen de rappel.

5. Boîtier de détecteur (10) selon la revendication 4, **caractérisé en ce que** le bouton poussoir est disposé sur l'élément intérieur (20) du couvercle de chambre de serrage (18) ou sur l'élément de capot (22) du couvercle de chambre de serrage (18), le moyen de rappel étant disposé sur l'élément intérieur (20) ou sur l'élément de capot (22).

6. Boîtier de détecteur (10) selon la revendication 4 ou 5, **caractérisé en ce que**, dans la position finale de l'élément de capot (22) dans la direction de verrouillage (40), le bouton poussoir est disposé au mois partiellement devant l'élément de capot (22) et le bouton poussoir présente une surface de retenue (26.1) contigüe à l'élément de capot (22) dans la position finale de l'élément de capot (22).

7. Boîtier de détecteur (10) selon une des revendications précédentes, **caractérisé en ce qu'**une surface de jonction court entre au moins une paroi latérale du socle de chambre de serrage (16) courant parallèlement à une direction de verrouillage (40) et au moins une paroi latérale du couvercle de chambre de serrage (18) courant parallèlement à la direction de verrouillage (40) et/ou court au moins partiellement selon un angle inférieur à α par rapport à la direction de verrouillage (40).

8. Boîtier de détecteur (10) selon une des revendications précédentes, **caractérisé en ce que** la direction de fermeture (42) forme avec la direction de verrouillage (40) un angle (β) de 0° minimum ou de 15° minimum ou de 30° minimum et de 90° maximum.

9. Boîtier de détecteur (10) selon une des revendications précédentes, caractérisé en ce boîtier de détecteur (10) est conforme à la norme IP 68 ou à la norme IP 369K.

10. Boîtier de détecteur (10) selon une des revendications précédentes, **caractérisé en ce que** le socle de chambre de serrage (16) et/ou le couvercle de chambre de serrage (18) comportent au moins un moyen de fixation (28) ou au moins un élément d'un moyen de fixation (28) pour fixer le boîtier de détecteur (10) sur une surface.

11. Boîtier de détecteur (10) selon une des revendications précédentes, **caractérisé en ce que** l'élément de capot (22) du couvercle de chambre de serrage (18) présente une courbure en forme de U dans un plan courant perpendiculairement à la direction de verrouillage (40).

12. Boîtier de détecteur (10) selon une des revendications précédentes, **caractérisé en ce que** ce boîtier de détecteur est entièrement constitué d'un ou plusieurs matériaux non électro-conducteurs.

13. Détecteur de proximité inductif ou détecteur de proximité capacitif, **caractérisé en ce que** ce détecteur de proximité comporte un boîtier de détecteur (10) selon une des revendications précédentes.
